# EUROPEAN PATENT SPECIFICATION

(11) **EP 4 485 679 B1**
(45) Date of publication and mention of the grant of the patent: **08.04.2026**
(21) Application number: 23759754.7
(22) Date of filing: 13.02.2023
(51) Int. Cl.: H01M 50/569, G01R 31/389, H01M 10/48, H01M 50/298

(54) **BATTERY PACK**
BATTERIEPACK
BLOC-BATTERIE

(30) Priority: 25.02.2022 JP 2022028529
(43) Date of publication of application: 01.01.2025
(73) Proprietor: Nuvoton Technology Corporation Japan, Nagaokakyo City, Kyoto 617-8520 (JP)
(72) Inventor: YOSHIKAWA, Susumu, Nagaokakyo City, Kyoto 617-8520 (JP); KOBAYASHI, Hitoshi, Nagaokakyo City, Kyoto 617-8520 (JP); FUJII, Keiichi, Nagaokakyo City, Kyoto 617-8520 (JP); KAWABE, Akira, Nagaokakyo City, Kyoto 617-8520 (JP)
(74) Representative: Novagraaf International SA
(86) International application number: PCT/JP2023/004799
(87) International publication number: WO 2023/162751

(56) References cited:
- JP-A- 2002 170 535
- JP-A- 2002 170 535
- JP-A- 2006 322 857
- JP-A- 2009 512 144
- JP-A- 2013 109 927
- JP-A- 2013 165 067
- JP-A- 2013 225 457
- JP-A- 2020 013 653
- JP-A- 2021 117 221
- US-A- 5 705 929
- US-A1- 2019 391 209
- US-B1- 7 148 708

## Description

### [Technical Field]

The present disclosure relates to a battery pack that includes an assembled battery in which secondary batteries such as lithium-ion batteries are connected in series or in parallel.

### [Background Art]

In recent years, there is a rapid increase in applications that use secondary batteries such as environmentally friendly vehicles including electric vehicles, and storage batteries for stably supplying renewable energy. Lithium-ion batteries (LiBs) are often used in the above-described applications because they have a high energy density.

Most in-vehicle batteries and storage batteries include an assembled battery in which a plurality of batteries are arranged and connected in series or in parallel. The assembled battery is required to have an increased capacity to enable electric power to be used for a long period of time. For this reason, the assembled battery is designed to have a structure in which a battery block including a plurality of batteries stacked in a plurality of layers is housed in a plastic outer case. In the assembled battery, the output voltage can be increased by connecting the plurality of batteries in series, and the battery run time can be extended by connecting the plurality of batteries in parallel. It is known that the use of lithium-ion batteries accelerates degradation caused by overcharge, overdischarge, or temperature, which may lead to smoking and firing, and eventually to a dangerous situation such as an explosion in the worst case. To address this problem, usually, a battery monitoring device is provided to bring the lithium-ion batteries under appropriate control.

Ordinarily, a battery monitoring device monitors voltage, current, and temperature of all secondary batteries that constitute an assembled battery to monitor the state of each battery by using data obtained by measuring the voltage, the current, and the temperature.

Patent Literature (PTL) 1 discloses a high output and high capacity battery pack that includes an assembled battery in which a plurality of battery cells are assembled.

In the battery pack disclosed in PTL 1, the assembled battery is formed by stacking the plurality of battery cells in the same direction, a circuit board that includes a battery monitoring device is provided at an end surface of the assembled battery, and the battery cells that constitute a battery block are connected to the circuit board provided at the end surface of the assembled battery using a plurality of voltage detecting wires. The plurality of voltage detecting wires are provided on a terminal surface in which electrode terminals of the battery cells are located in a space outside of the electrode terminals. The plurality of voltage detecting wires connected to the electrode terminals are drawn out to an end portion of the assembled battery on the circuit board side in the lengthwise direction of the assembled battery.

Also, PTL 2 discloses a technique for measuring the impedance of a battery as a method for monitoring the state of the battery. PTL 2 proposes a battery monitoring device that can monitor the state of a battery in real time by measuring internal impedance characteristics of the battery based on electrochemical impedance spectroscopy (EIS). PTL 2 also discloses that, with this battery monitoring device, it is also possible to manage the state of the battery by measuring the impedance of the battery and estimating the state of charge (SOC) and the state of health (SOH) of the battery that correspond to the measured impedance by referring to a predetermined correlation relationship between impedance, SOC, and SOH.

However, there is a problem in that a response signal obtained by internal impedance characteristics is a very weak signal, and is therefore susceptible to external influences, such as, for example, an electromagnetic induction disturbance in which an induced electromotive force is generated in an electric circuit path in which a response signal is input and output when measuring the internal impedance of the battery, and the measurement cannot be performed appropriately due to the influence of the induced electromotive force.

To address the problem, PTL 3 proposes a battery monitoring device, wherein the influence of an induced electromotive force can be suppressed by defining the range of an area surrounded by an electric circuit path in which an induced electromotive force is generated to be minimum.

### [Citation List]

### [Patent Literature]

[PTL 1]
   Japanese Unexamined Patent Application Publication No. 2015-185414
[PTL 2]
   Japanese Patent No. 5403437
[PTL 3]
   Japanese Unexamined Patent Application Publication No. 2021-117221

### [Summary of Invention]

### [Technical Problem]

An assembled battery that includes a plurality of batteries has a problem in that, when wiring-derived impedance is relatively large, it is not possible to accurately measure battery-derived impedance such as electrode impedance and electrolyte impedance. There is also another problem in that a response signal obtained by internal impedance characteristics is a very weak signal, and is therefore susceptible to external influences.

Also, wiring such as a voltage detecting wire or a bus bar that connects a battery and a battery monitoring device has a resistance value, and the impedance varies along with the wiring length or the like. In particular, when a measurement target battery has a low impedance, the influence of wiring length and the like is relatively large. In order to suppress the influence, the wiring routed in the battery pack needs to be as short as possible.

Also, in the battery pack disclosed in PTL 3, a signal generator that applies an AC current is connected to each battery electrode terminal. In the case where the battery monitoring device and the assembled battery are connected using a current applying wire for applying an AC current to the assembled battery, the current applying wire serves as a source of electromagnetic induction disturbance, and affects the detection of impedance.

In view of the above, the present disclosure provides a battery pack, wherein it is possible to measure the internal impedances of a plurality of batteries that constitute an assembled battery with high accuracy.

### [Solution to Problem]

A battery pack according to an aspect of the present disclosure includes: an assembled battery in which a plurality of batteries are connected; a current applying wire for applying an electric current to the assembled battery; a plurality of voltage detecting wires for detecting voltages of the plurality of batteries; and a battery monitoring device that measures internal impedances of the plurality of batteries. The battery monitoring device is located between a positive electrode-side battery terminal and a negative electrode-side battery terminal of each of the plurality of batteries included in the assembled battery, and the plurality of voltage detecting wires are routed radially from the battery monitoring device.

### [Advantageous Effects of Invention]

With the battery back according to the aspect of the present disclosure, it is possible to measure the internal impedances of a plurality of batteries that constitute an assembled battery with high accuracy.

### [Brief Description of Drawings]

[FIG. 1]

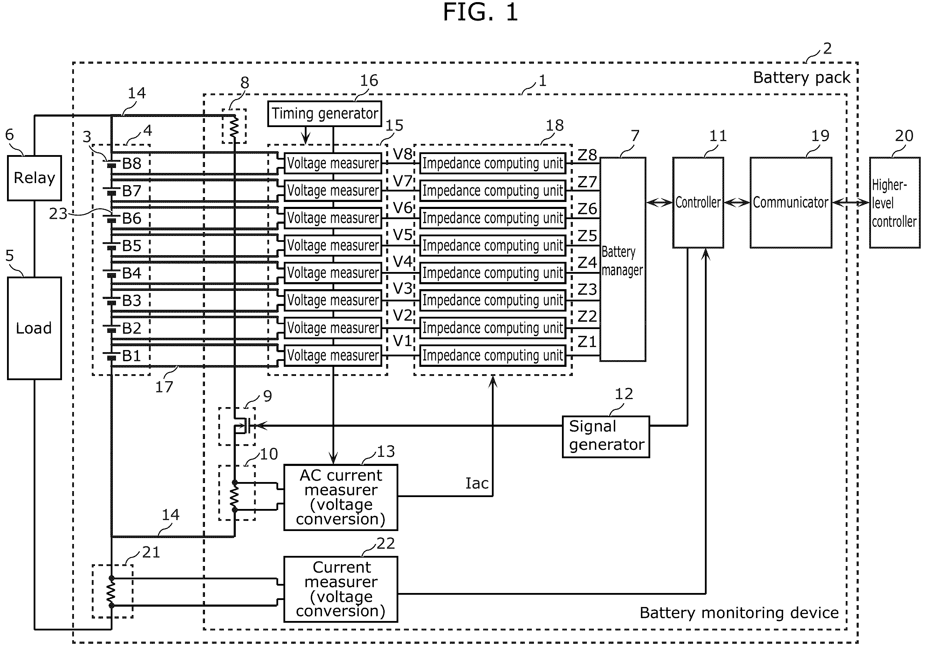

   FIG. 1 is a schematic configuration diagram showing an example of a battery pack according to Embodiment 1.
[FIG. 2A]

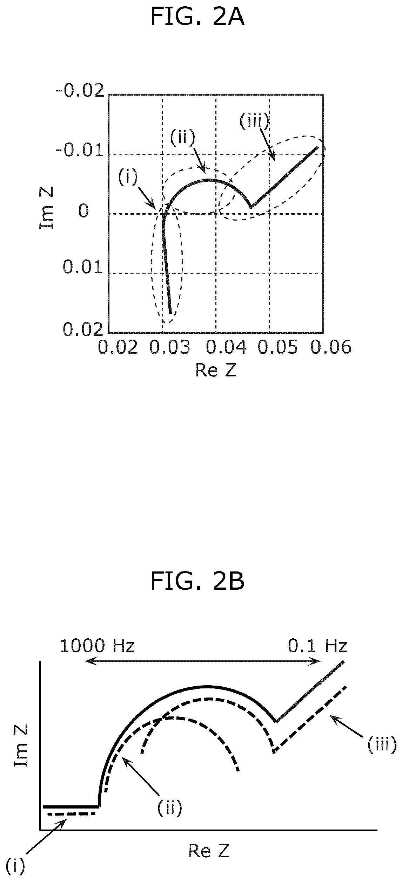

   FIG. 2A is a diagram illustrating a Nyquist plot.
[FIG. 2B]
   FIG. 2B is a diagram illustrating a Nyquist plot.
[FIG. 3]

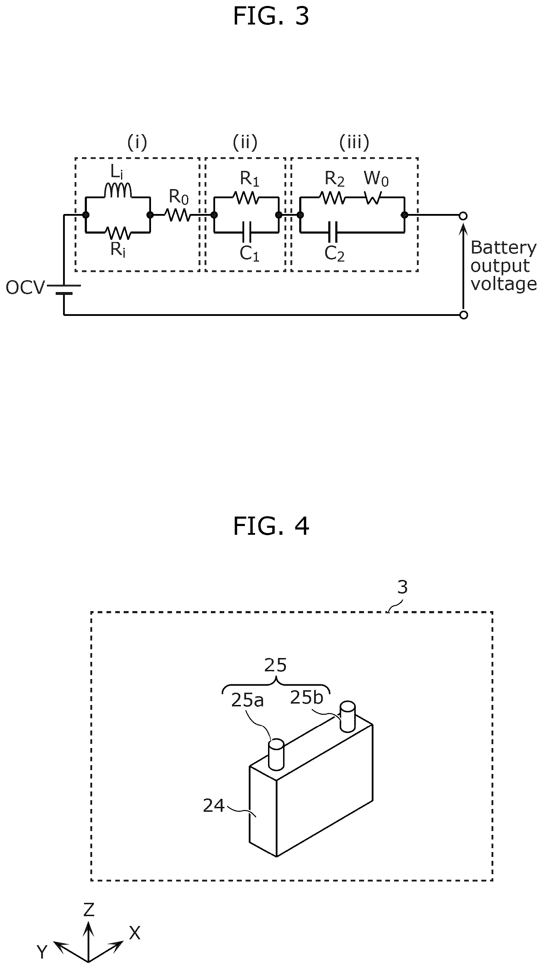

   FIG. 3 is a diagram illustrating a correlation between a Nyquist plot and a battery equivalent circuit.
[FIG. 4]
   FIG. 4 is a perspective view showing an example of a battery.
[FIG. 5]

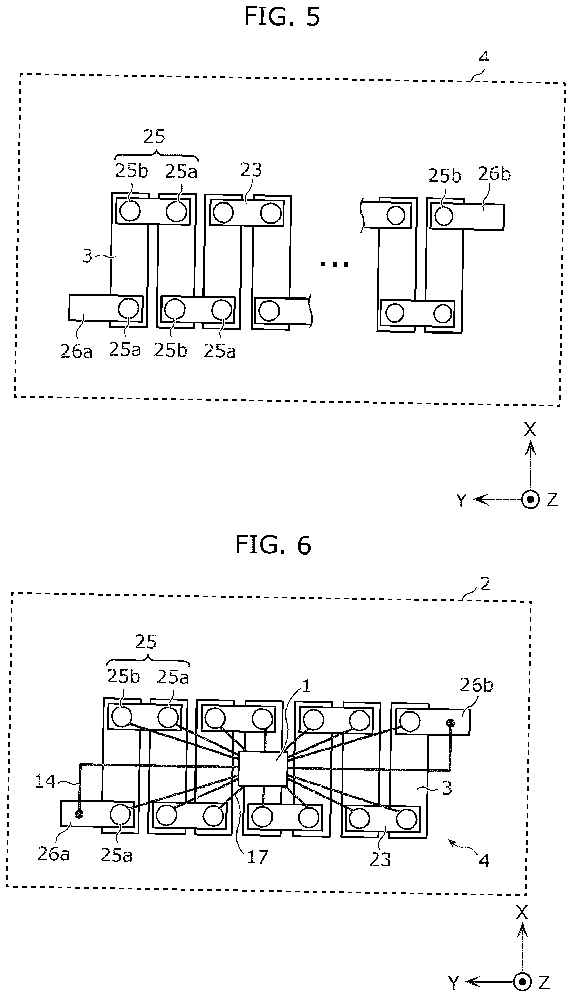

   FIG. 5 is a plan view showing an example of an assembled battery.
[FIG. 6]
   FIG. 6 is a plan view showing an example of a battery pack according to Embodiment 1.
[FIG. 7]

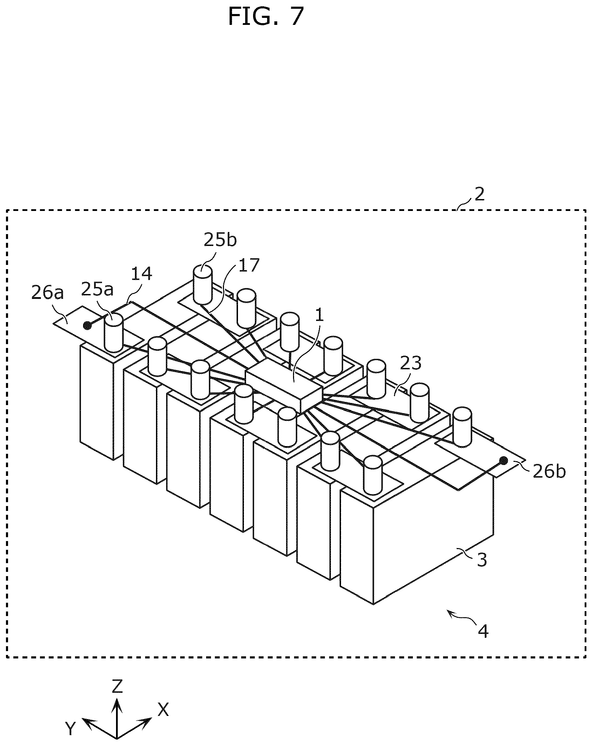

   FIG. 7 is a perspective view showing the example of the battery pack according to Embodiment 1.
[FIG. 8]

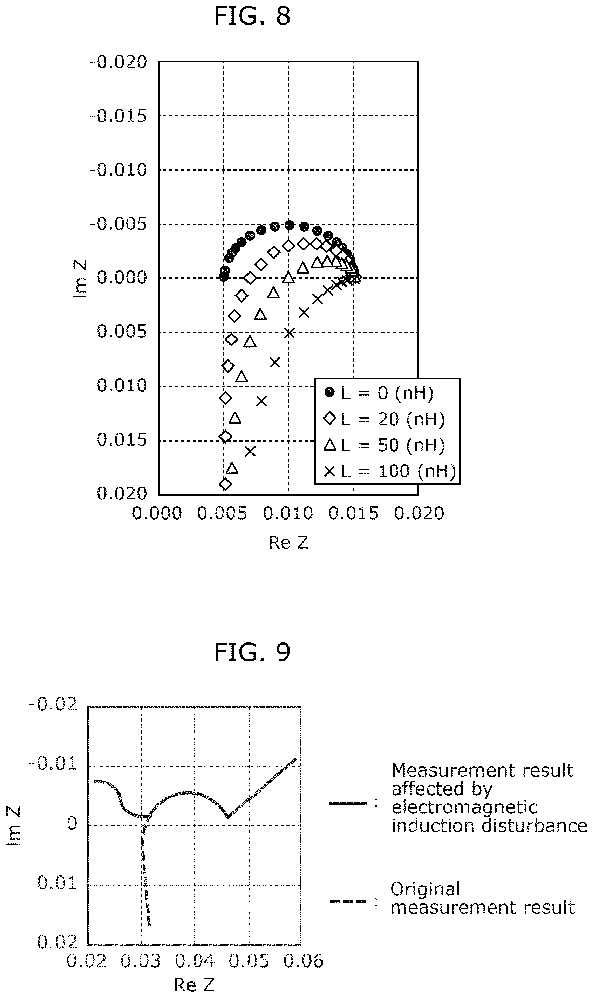

   FIG. 8 is a diagram showing the influence of an inductor component of wiring.
[FIG. 9]
   FIG. 9 is a diagram showing the influence of an electromagnetic induction disturbance.
[FIG. 10]

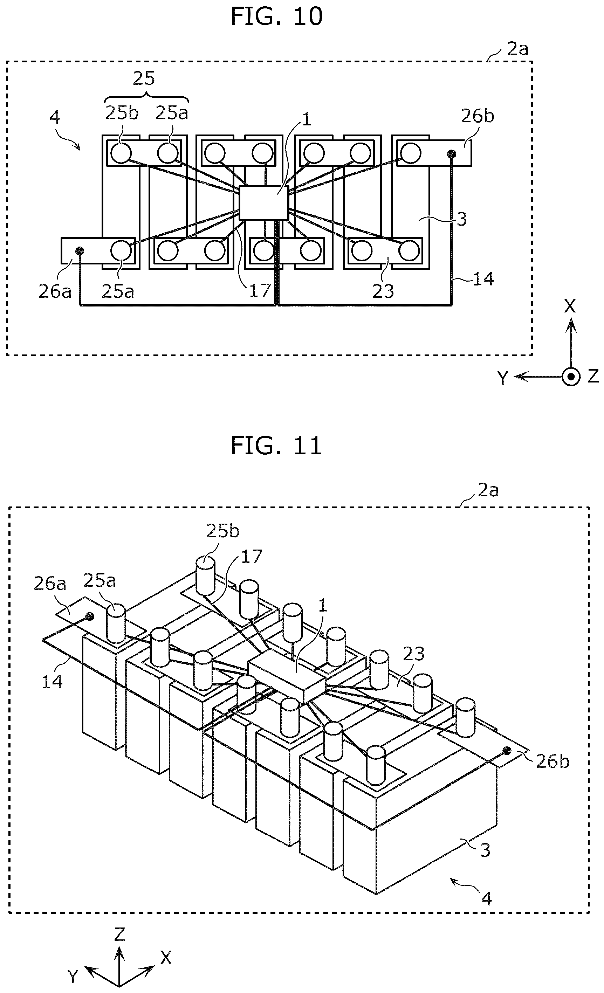

   FIG. 10 is a plan view showing an example of a battery pack according to Embodiment 2.
[FIG. 11]
   FIG. 11 is a perspective view showing the example of the battery pack according to Embodiment 2.
[FIG. 12]

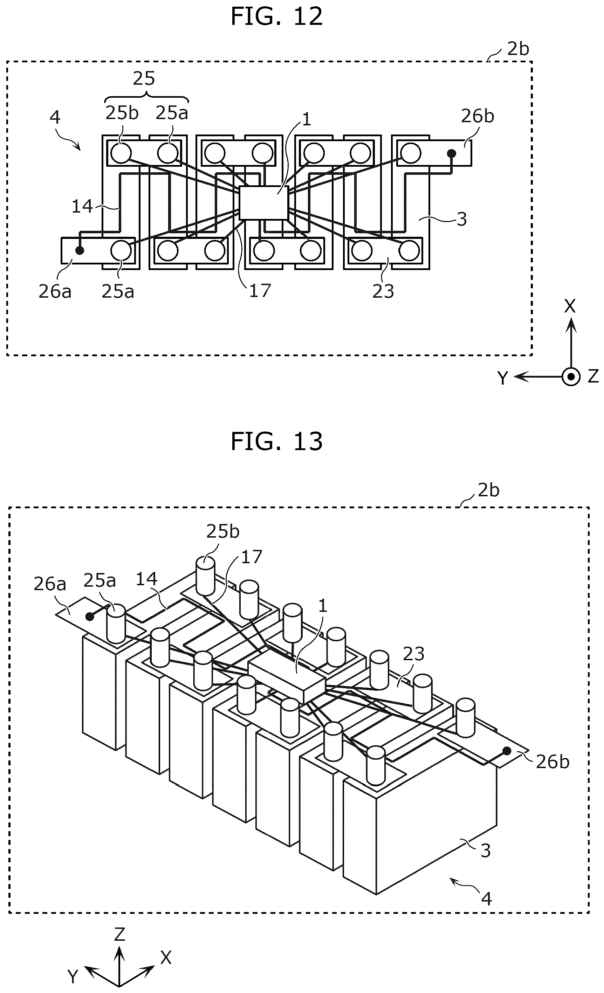

   FIG. 12 is a plan view showing an example of a battery pack according to Embodiment 3.
[FIG. 13]
   FIG. 13 is a perspective view showing the example of the battery pack according to Embodiment 3.
[FIG. 14A]

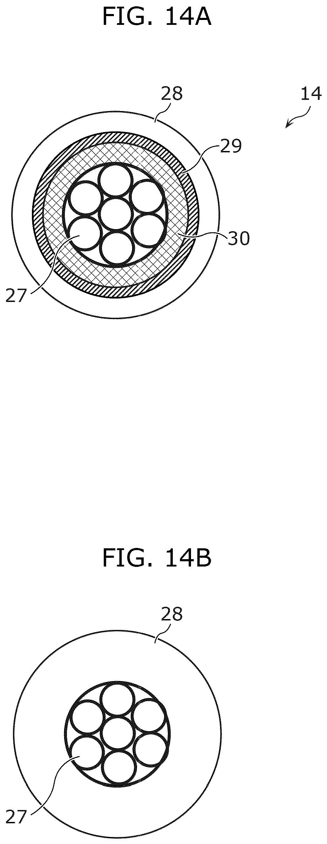

   FIG. 14A is a diagram illustrating a first example of a shielding part according to Embodiment 4.
[FIG. 14B]
   FIG. 14B is a diagram showing an example of wiring that is not covered with the shielding part.
[FIG. 15]

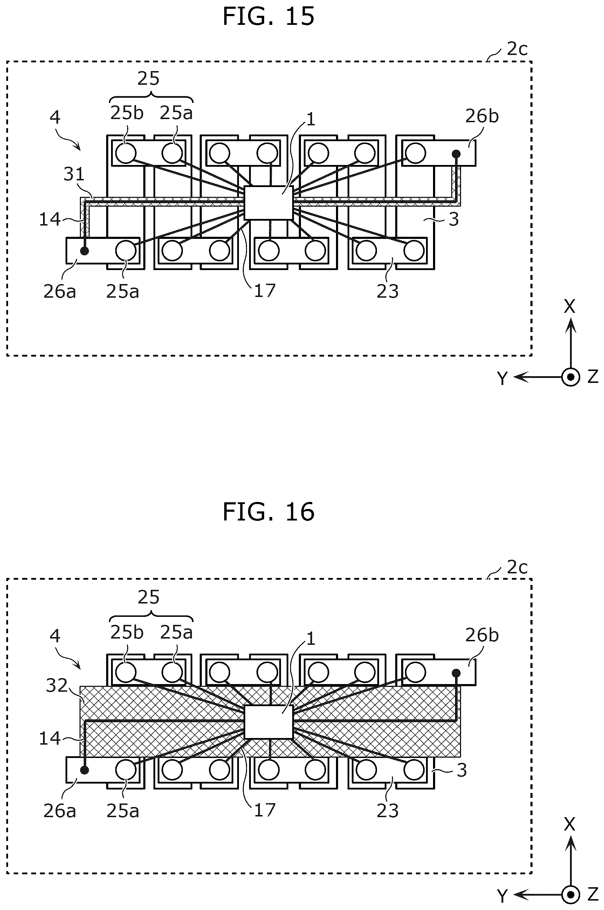

   FIG. 15 is a diagram illustrating a second example of the shielding part according to Embodiment 4.
[FIG. 16]
   FIG. 16 is a diagram illustrating a third example of the shielding part according to Embodiment 4.
[FIG. 17]

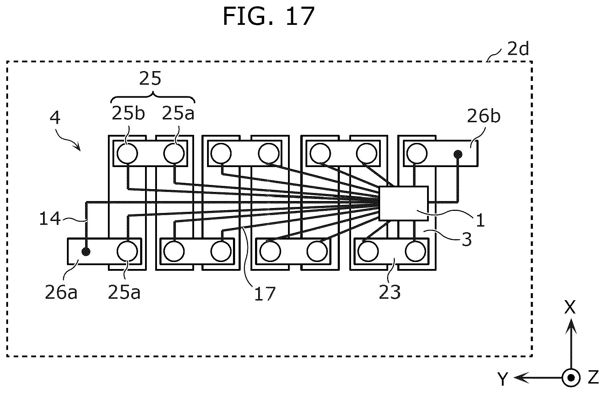

   FIG. 17 is a plan view showing an example of a battery pack according to Embodiment 5.
[FIG. 18]

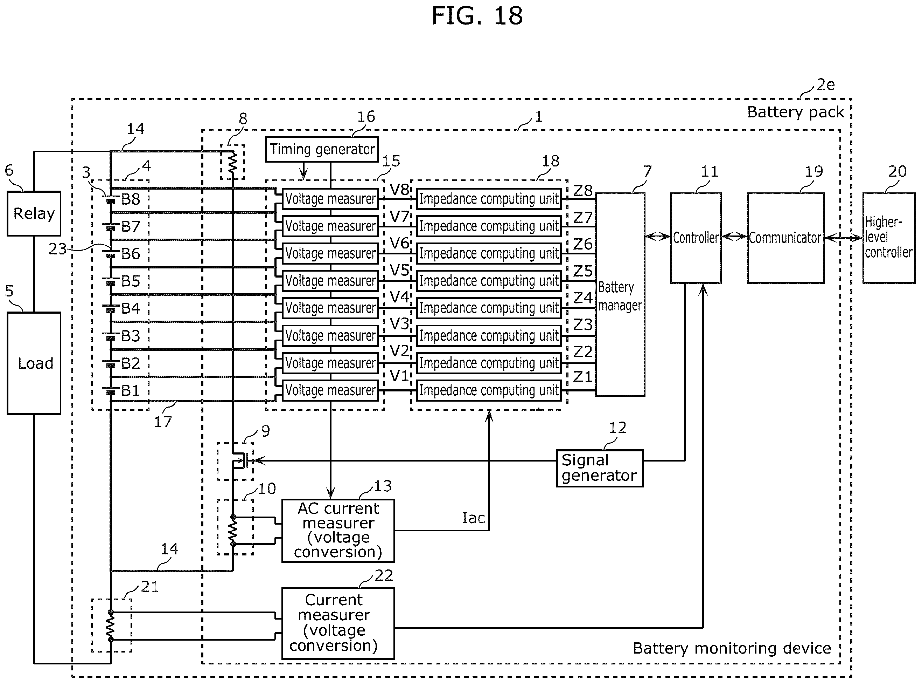

   FIG. 18 is a schematic configuration diagram showing an example of a battery pack according to Embodiment 6.
[FIG. 19]

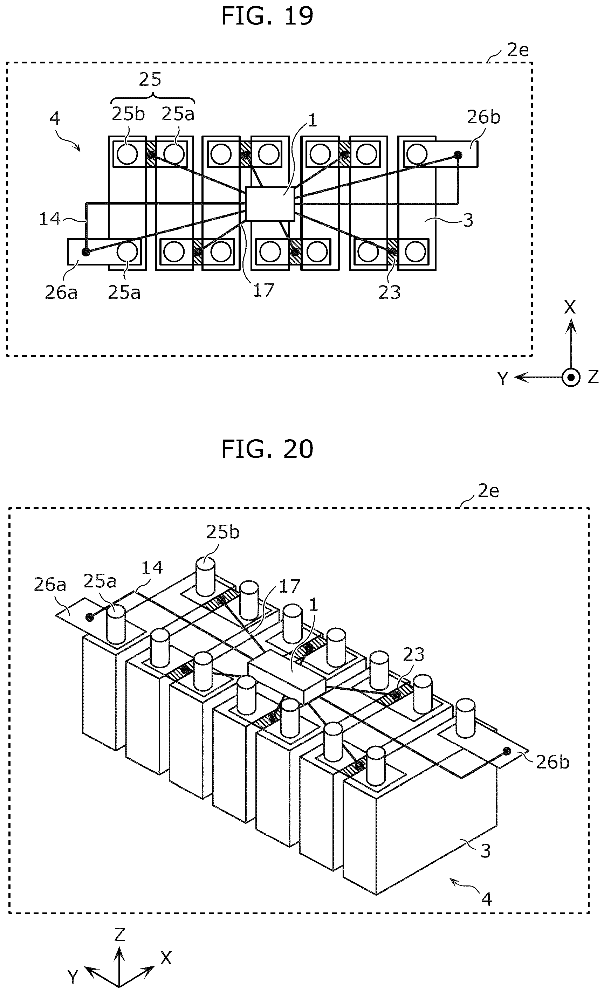

   FIG. 19 is a plan view showing the example of the battery pack according to Embodiment 6.
[FIG. 20]
   FIG. 20 is a perspective view showing the example of the battery pack according to Embodiment 6.
[FIG. 21]

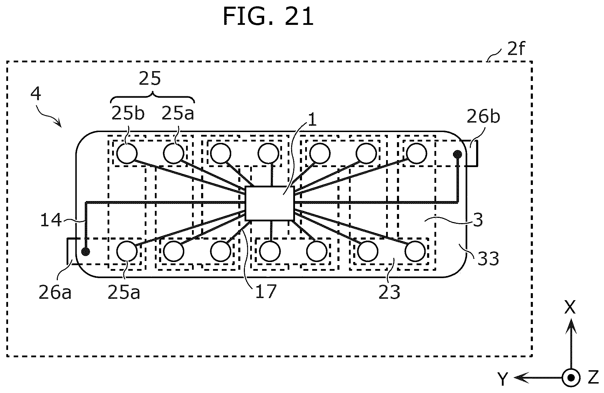

   FIG. 21 is a plan view showing an example of a battery pack according to another embodiment.

### [Description of Embodiments]

A battery pack according to an aspect of the present disclosure includes: an assembled battery in which a plurality of batteries are connected; a current applying wire for applying an electric current to the assembled battery; a plurality of voltage detecting wires for detecting voltages of the plurality of batteries; and a battery monitoring device that measures internal impedances of the plurality of batteries, wherein the battery monitoring device is located between a positive electrode-side battery terminal and a negative electrode-side battery terminal of each of the plurality of batteries included in the assembled battery, and the plurality of voltage detecting wires are routed radially from the battery monitoring device.

The plurality of voltage detecting wires are routed radially from the battery monitoring device toward the positive electrode-side battery terminal and the negative electrode-side battery terminal of each of the plurality of batteries, and thus the lengths of the plurality of voltage detecting wires can be made shortest, and the resistance values of the plurality of voltage detecting wires can be reduced. For this reason, it is possible to suppress the influence of resistance values of the plurality of voltage detecting wires, and measure the internal impedances of the plurality of batteries that constitute the assembled battery with high accuracy.

For example, the assembled battery and the battery monitoring device may be connected using the current applying wire, and an alternating (AC) current controlled by the battery monitoring device may be applied to the assembled battery via the current applying wire. For example, the battery monitoring device may measure internal AC impedances of the plurality of batteries based on the AC current applied to the assembled battery and the voltages of the plurality of batteries.

With this configuration, it is possible to measure the internal AC impedances of the plurality of batteries that constitute the assembled battery with high accuracy.

For example, the current applying wire may be routed to prevent the current applying wire from being parallel to the plurality of voltage detecting wires, or routed to minimize a portion of the current applying wire parallel to the plurality of voltage detecting wires.

A large AC current may be applied to the current applying wire, and thus a mutual inductance that occurs when the current applying wire is in parallel to the voltage detecting wires is also large. To address this problem, by routing the current applying wire to prevent the current applying wire from being parallel to the plurality of voltage detecting wires, or by routing the current applying wire to minimize a portion of the current applying wire parallel to the plurality of voltage detecting wires, it is possible to suppress an electromagnetic induction disturbance caused by the mutual inductance between the current applying wire and the voltage detecting wires. With this configuration, it is possible to measure the internal impedances of the plurality of batteries that constitute the assembled battery with even higher accuracy.

For example, the current applying wire may be located between the positive electrode-side battery terminal and the negative electrode-side battery terminal of each of the plurality of batteries.

As a result of the current applying wire being located between the positive electrode-side battery terminal and the negative electrode-side battery terminal of each of the plurality of batteries, the current applying wire can be extended from the battery monitoring device to a positive electrode-side assembled battery terminal and a negative electrode-side assembled battery terminal of the assembled battery in a region between the positive electrode-side battery terminal and the negative electrode-side battery terminal of each of the plurality of batteries. For this reason, the current applying wire can be shortened, and the resistance value of the current applying wire can be reduced. Accordingly, it is also possible to suppress the influence of resistance value of the current applying wire, and measure the internal impedances of the plurality of batteries that constitute the assembled battery with even higher accuracy.

For example, the current applying wire may be located outside a region between the positive electrode-side battery terminal and the negative electrode-side battery terminal of each of the plurality of batteries.

Because the plurality of voltage detecting wires are routed in the region between the positive electrode-side battery terminal and the negative electrode-side battery terminal of each of the plurality of batteries, as a result of the current applying wire being located outside the region between the positive electrode-side battery terminal and the negative electrode-side battery terminal of each of the plurality of batteries, it is possible to suppress an electromagnetic induction disturbance caused by the mutual inductance between the current applying wire and the voltage detecting wires. With this configuration, it is possible to measure the internal impedances of the plurality of batteries that constitute the assembled battery with even higher accuracy.

For example, the current applying wire may be routed to weaken a magnetic field generated by the current applying wire.

The magnetic field generated by the current applying wire is weakened, and it is therefore possible to suppress an electromagnetic induction disturbance caused by the mutual inductance between the current applying wire and the voltage detecting wires. With this configuration, it is possible to measure the internal impedances of the plurality of batteries that constitute the assembled battery with even higher accuracy.

For example, the assembled battery may be configured by connecting, using a bus bar, a battery terminal of a battery included in the plurality of batteries to a battery terminal of an adjacent battery included in the plurality of batteries, the adjacent battery being adjacent to the battery, and a voltage detecting wire included in the plurality of voltage detecting wires may be connected to the bus bar at a position between the two battery terminals.

The positive electrode-side battery terminal and the negative electrode-side battery terminal of each pair of adjacent batteries are connected using a bus bar, and thus the bus bar has substantially the same potential as that of the positive electrode-side battery terminal and the negative electrode-side battery terminal. For this reason, even by simply connecting a voltage detecting wire to the bus bar without connecting voltage detecting wires to the positive electrode-side battery terminal and the negative electrode-side battery terminal, respectively, the voltages of adjacent batteries can be detected, and the number of voltage detecting wires can be reduced. That is, the influence of inductor component and induced electromotive force during impedance measurement of the batteries can be suppressed in accordance with the reduction in the number of voltage detecting wires. With this configuration, it is possible to measure the internal impedances of the plurality of batteries that constitute the assembled battery with even higher accuracy.

For example, the voltage detecting wire included in the plurality of voltage detecting wires may be connected to the bus bar at a position equidistant from the two battery terminals.

As a result of voltage detecting wires being connected to the bus bar at a position equidistant from the two battery terminals (the positive electrode-side battery terminal and the negative electrode-side battery terminal), the influence of resistance component of the bus bar during detection of the voltages of adjacent batteries can be made equal between the adjacent batteries.

For example, the battery pack may further include a shielding part that shields an electric field or a magnetic field generated by each of the plurality of batteries or the current applying wire.

With the shielding part, it is possible to suppress the influence of electric field or magnetic field generated by the current applying wire and each of the plurality of batteries.

For example, the shielding part may be a shield that covers a center conductor of the current applying wire, and may shield the electric field or the magnetic field generated by the current applying wire.

As described above, with the shield that covers the current applying wire, it is possible to suppress the influence of electric field or magnetic field generated by the current applying wire.

For example, the shielding part may be a sheet-like shield provided between the current applying wire and the plurality of voltage detecting wires, and may shield the electric field or the magnetic field generated by the current applying wire.

As described above, with the sheet-like shield provided between the current applying wire and the plurality of voltage detecting wires, it is possible to suppress the influence of electric field or magnetic field generated by the current applying wire.

For example, the shielding part may be a sheet-like shield provided between (i) the plurality of batteries and (ii) the current applying wire and the plurality of voltage detecting wires, and may shield the electric field or the magnetic field generated by each of the plurality of batteries.

As described above, with the sheet-like shield provided between (i) the plurality of batteries and (ii) the current applying wire and the plurality of voltage detecting wires, it is possible to suppress the influence of electric field or magnetic field generated by each of the plurality of batteries.

Hereinafter, embodiments will be described with reference to the drawings. The embodiments described below show generic or specific examples. The numerical values, shapes, materials, structural elements, the arrangement and connection of the structural elements, and the like shown in the following embodiments are merely examples, and therefore are not intended to limit the scope of the present disclosure. Also, among the structural elements described in the following embodiments, structural elements not recited in any one of the independent claims are described as arbitrary structural elements.

Note that the diagrams are schematic representations, and thus are not necessarily true to scale. Also, in the diagrams, structural elements that are substantially the same are given the same reference numerals, and a redundant description may be omitted or simplified.

### (Embodiment 1)

Battery pack 2 according to Embodiment 1 will be described.

FIG. 1 is a schematic configuration diagram showing an example of battery pack 2 according to Embodiment 1. FIG. 1 also shows, in addition to battery pack 2, higher-level controller 20, load 5, and relay 6.

Hereinafter, an example will be described in which battery pack 2 is applied to a power supply system included in a vehicle (for example, a hybrid vehicle or an electric vehicle).

As shown in FIG. 1, battery pack 2 includes: assembled battery 4 in which a plurality of batteries 3 (for example, batteries B1 to B8) are combined and connected; battery monitoring device 1 that monitors the batteries; current applying wire 14; a plurality of voltage detecting wires 17; and shunt resistor 21. Batteries 3 are secondary batteries such as lithium-ion batteries.

Relay 6 that switches the connection between assembled battery 4 and load 5 between ON and OFF is provided between assembled battery 4 and load 5 (corresponding to a motor, an inverter, or an accelerator). An application is operated in response to relay 6 switching the connection between assembled battery 4 and load 5 between ON and OFF. In the case where the plurality of batteries 3 are storage batteries, load 5 may be a charger. Assembled battery 4 and battery monitoring device 1 are connected using current applying wire 14 and the plurality of voltage detecting wires 17.

Battery monitoring device 1 is a device that measures the internal impedances of the plurality of batteries 3. For example, battery monitoring device 1 measures the internal AC impedances of the plurality of batteries 3. Also, for example, battery monitoring device 1 measures the internal impedance (for example, internal AC impedance) of each of the plurality of batteries 3. Battery monitoring device 1 measures the internal AC impedances of the plurality of batteries 3 (for example, the internal AC impedance of each of the plurality of batteries 3) based on the AC current applied to assembled battery 4 and the voltages of the plurality of batteries 3 that constitute assembled battery 4 (for example, the voltage of each of the plurality of batteries 3). For example, battery monitoring device 1 measures the internal AC impedance characteristics of batteries 3 based on EIS, and monitors the state of each of batteries 3 in real time. Battery monitoring device 1 includes battery manager 7, load resistor 8, switching element 9, shunt resistor 10, controller 11, signal generator 12, AC current measurer 13, voltage measurer 15, timing generator 16, impedance computing unit 18, communicator 19, shunt resistor 21, and current measurer 22.

Battery manager 7, controller 11, signal generator 12, AC current measurer 13, voltage measurer 15, timing generator 16, and impedance computing unit 18 are functional structural elements for measuring the internal AC impedance of assembled battery 4 (specifically, each of the plurality of batteries 3 that constitute assembled battery 4).

Load resistor 8, switching element 9, and shunt resistor 10 are circuits for measuring the internal AC impedance of assembled battery 4.

As a result of controller 11 controlling signal generator 12 that sweeps AC signals, switching element 9 can be switched between ON and OFF at a specific frequency. Accordingly, an AC current at a specific frequency is output from assembled battery 4. AC current measurer 13 measures voltage generated in shunt resistor 10 (or in other words, voltage converted from the AC current output from assembled battery 4). Load resistor 8 and assembled battery 4 are connected via current applying wire 14, and shunt resistor 10 and assembled battery 4 are also connected via current applying wire 14. Load resistor 8 and shunt resistor 10 are included in battery monitoring device 1, and thus battery monitoring device 1 and assembled battery 4 are connected via current applying wire 14. Current applying wire 14 is a wiring for applying an AC current to assembled battery 4. Current applying wire 14 is, for example, a conductor wire.

Voltage measurer 15 measures the voltages of the plurality of batteries 3 that constitute assembled battery 4. Voltage measurer 15 may measure the voltages of all batteries 3 that constitute assembled battery 4. Alternatively, voltage measurer 15 may measure the voltages of a few (for example, at least two) of batteries 3 that constitute assembled battery 4. That is, assembled battery 4 may include batteries 3 whose voltage is not measured by voltage measurer 15. Also, because voltage measurer 15 measures the voltages of the plurality of batteries 3 that constitute assembled battery 4 at the same timing, the measurement timing is set by controller 11 via timing generator 16.

Voltage measurer 15 is connected to the plurality of batteries 3 via the plurality of voltage detecting wires 17 to measure the voltages of the plurality of batteries 3 (for example, the voltage of each of the plurality of batteries 3). The plurality of voltage detecting wires 17 are wirings for detecting the voltages of the plurality of batteries 3 (for example, the voltage of each of the plurality of batteries 3). For example, as shown in FIG. 1, voltage detecting wires 17 are connected to a positive electrode-side battery terminal and a negative electrode-side battery terminal of each of the plurality of batteries 3, respectively. In the example shown in FIG. 1, sixteen voltage detecting wires 17 are provided for eight batteries B1 to B8. Voltage detecting wires 17 are, for example, conductor wires.

Voltages V1 to V8 of batteries B1 to B8 measured by voltage measurer 15 and current value Iac measured by AC current measurer 13 and subjected to voltage conversion are used by impedance computing unit 18 to calculate impedances Z1 to Z8 of batteries B1 to B8 (voltage ÷ current). Impedances Z1 to Z8 are complex numbers, and real portion ReZ and imaginary portion ImZ are calculated for each of batteries B1 to B8. Complex impedance values Z1 to Z8 of batteries B1 to B8 are output from impedance computing unit 18 to battery manager 7, and battery manager 7 determines SOC, SOH, an abnormal condition (a breakdown or a degradation), and the like of batteries B1 to B8. The SOC, the SOH, the abnormal condition, and the like of batteries B1 to B8 are notified to higher-level controller 20 via controller 11 and communicator 19. Higher-level controller 20 performs control according to the SOC, the SOH, the abnormal condition, and the like that have been notified.

Impedance computing unit 18 calculates the complex impedances of batteries 3, the complex impedance being the ratio between the voltage measured by voltage measurer 15 and the current measured by AC current measurer 13 at each frequency when an AC current is output from assembled battery 4 at each frequency by signal generator 12. By plotting the calculated complex impedances on a complex plane, Nyquist plot diagrams as shown in FIGS. 2A and 2B can be obtained.

FIGS. 2A and 2B are diagrams illustrating Nyquist plots. In FIGS. 2A and 2B, the horizontal axis indicates real portion ReZ of complex impedance Z, and the vertical axis indicates imaginary portion ImZ of complex impedance Z.

With Nyquist plot diagrams as shown in FIGS. 2A and 2B, for example, by dividing into regions (i) to (iii), the impedance components of the lithium-ion batteries can be analyzed. Region (i) corresponds to the impedance of transfer resistance in the electrolyte solution of the lithium-ion battery and the wiring. The semicircular portions of regions (ii) and (iii) correspond to the impedance of charge transfer resistance of the lithium-ion battery. Region (ii) corresponds to the impedance of the negative electrode. Region (iii) corresponds to the impedance of the positive electrode. In a low-frequency region of a region indicated by ImZ < 0, there is a linear portion angled at about 45°, to which the influence of Warburg impedance of the lithium-ion battery is reflected. From the Nyquist plot diagrams obtained in the above-described manner, for example, a battery equivalent circuit as shown in FIG. 3 can be estimated.

FIG. 3 is a diagram illustrating a correlation between a Nyquist plot and a battery equivalent circuit.

FIG. 3 shows an example of an internal resistance equivalent circuit of a lithium-ion battery. In the equivalent circuit shown in this example, resistor R₀ corresponds to the transfer resistance in the electrolyte solution. Resistor R₁ corresponds to the charge transfer resistance of the negative electrode. Resistor R₂ corresponds to the charge transfer resistance of the positive electrode. A wiring is defined by a parallel circuit that includes inductor Lᵢ and resistor Rᵢ. Also, Warburg resistor W₀ indicates diffusion, and is connected to resistor R₂ in series. A circuit in which resistor R₀ and a parallel circuit that includes inductor Lᵢ and resistor Rᵢ are connected in series corresponds to region (i) in the Nyquist plot diagrams shown in FIGS. 2A and 2B. An RC parallel circuit that includes resistor R₁ and capacitor C₁ corresponds to region (ii) in the Nyquist plot diagrams shown in FIGS. 2A and 2B. An RC parallel circuit in which a series circuit that includes resistor R₂ and Warburg resistor W0 and capacitor C₂ are connected in parallel corresponds to region (iii) in the Nyquist plot diagrams shown in FIGS. 2A and 2B.

Next, a structure of battery 3 will be described with reference to FIG. 4.

FIG. 4 is a perspective view showing an example of battery 3.

As shown in FIG. 4, battery 3 is formed in a flat rectangular parallelepiped shape. Electrodes, a separator, an electrolyte solution, and the like are housed in housing 24. On the upper surface of battery 3, bolt-shaped battery terminals 25 (positive electrode-side battery terminal 25a and negative electrode-side battery terminal 25b) that are connected to the electrodes are provided at opposing ends of battery 3 in the lengthwise direction (X axis direction). Positive electrode-side battery terminal 25a and negative electrode-side battery terminal 25b protrude upward (Z axis plus direction) to the same extent from housing 24.

Next, a structure of assembled battery 4 in which the plurality of batteries 3 are connected will be described with reference to FIG. 5.

FIG. 5 is a plan view showing an example of assembled battery 4. The plan views shown below including the plan view of FIG. 5 are views when assembled battery 4 is viewed from the upper surface side of battery 3, or in other words, when assembled battery 4 is viewed from the surface side on which battery terminals 25 are provided.

In assembled battery 4, housings 24 of batteries 3 are arranged in the widthwise direction (Y axis direction) such that their side surfaces are adjacent. Batteries 3 are arranged such that positive electrode-side battery terminal 25a and negative electrode-side battery terminal 25b of adjacent batteries 3 are alternately provided. Specifically, in battery 3 that is adjacent to another battery 3 in which battery terminals 25 are provided in the order of positive electrode-side battery terminal 25a and negative electrode-side battery terminal 25b in the X axis plus direction, battery terminals 25 are provided in the order of negative electrode-side battery terminal 25b and positive electrode-side battery terminal 25a in the X axis plus direction. Positive electrode-side battery terminal 25a of battery 3 is connected to negative electrode-side battery terminal 25b of another battery 3 that is adjacent on one side via bus bar 23 that is made of a conductive material such that the plurality of batteries 3 are connected in series. Also, negative electrode-side battery terminal 25b of battery 3 is connected to positive electrode-side battery terminal 25a of another battery 3 that is adjacent on the other side via bus bar 23. Assembled battery 4 is configured by connecting the plurality of batteries 3 in series as described above to have an intended battery capacity and an intended battery voltage. Assembled battery 4 may be configured by connecting the plurality of batteries 3 in parallel.

Bus bars 23 are each formed in the shape of a thin plate with a length that extends over positive electrode-side battery terminal 25a of battery 3 and negative electrode-side battery terminal 25b of adjacent battery 3, and has sufficient conductivity. Bus bars 23 are fastened to bolt-shaped battery terminals 25 by using nuts.

Positive electrode-side assembled battery terminal 26a is connected to positive electrode-side battery terminal 25a of one of the plurality of batteries 3 that are connected in series that is located on one end side (for example, battery 3 located on the leftmost side in FIG. 5), and negative electrode-side assembled battery terminal 26b is connected to negative electrode-side battery terminal 25b of battery 3 located on the other end side (for example, battery 3 located on the rightmost side in FIG. 5). Positive electrode-side assembled battery terminal 26a and negative electrode-side assembled battery terminal 26b are provided to supply electric power from assembled battery 4 to external load 5.

Next, a structure of battery pack 2 according to Embodiment 1 will be described with reference to FIGS. 6 and 7.

FIG. 6 is a plan view showing an example of battery pack 2 according to Embodiment 1.

FIG. 7 is a perspective view showing the example of battery pack 2 according to Embodiment 1.

In FIGS. 6 and 7, battery monitoring device 1, the plurality of batteries 3 that constitute assembled battery 4, current applying wire 14 that connects assembled battery 4 and battery monitoring device 1, and the plurality of voltage detecting wires 17 are shown. Battery monitoring device 1 is located between positive electrode-side battery terminal 25a and negative electrode-side battery terminal 25b of each of batteries 3 that constitute assembled battery 4 when assembled battery 4 is viewed in a plan view. For example, one voltage detecting wire 17 is connected to one battery terminal 25 (positive electrode-side battery terminal 25a or negative electrode-side battery terminal 25b), and two voltage detecting wires 17 are connected to one battery 3. The plurality of voltage detecting wires 17 are routed radially from battery monitoring device 1. As shown in FIGS. 6 and 7, for example, battery monitoring device 1 is located at a position that is substantially at the center of assembled battery 4 in the lengthwise direction and substantially at the center of assembled battery 4 in the widthwise direction, and the plurality of voltage detecting wires 17 are routed radially in all directions of battery monitoring device 1 from battery monitoring device 1 when assembled battery 4 is viewed in a plan view. The number of batteries 3 whose internal AC impedance is measured by battery monitoring device 1 may be at least two, and the number of voltage detecting wires 17 may be at least four. For example, when four voltage detecting wires 17 are routed in different directions for two batteries 3, it can be said that four voltage detecting wires 17 are routed radially.

Current applying wire 14 connects battery monitoring device 1 and positive electrode-side assembled battery terminal 26a, and also connects battery monitoring device 1 and negative electrode-side assembled battery terminal 26b. As shown in FIGS. 6 and 7, current applying wire 14 is routed to prevent the current applying wire from being parallel to the plurality of voltage detecting wires 17. In the case where, due to the design of battery pack 2, current applying wire 14 and at least one voltage detecting wire 17 are inevitably parallel, current applying wire 14 is routed to minimize a portion of current applying wire 14 parallel to voltage detecting wire 17.

Also, as shown in FIGS. 6 and 7, for example, current applying wire 14 is located between positive electrode-side battery terminal 25a and negative electrode-side battery terminal 25b of each of the plurality of batteries 3 when assembled battery 4 is viewed in a plan view.

By radially routing the plurality of voltage detecting wires 17, voltage detecting wires 17 can be provided along the shortest path between each battery terminal 25 and battery monitoring device 1, and thus the lengths of the plurality of voltage detecting wires 17 can be made shortest. The wirings such as voltage detecting wires 17, current applying wire 14, and bus bars 23 each have a resistance value, and the resistance value of each wiring varies according to the material, thickness, and length of the wiring. For example, taking the length of the wiring as an example, as the length of the wiring increases, the inductor component of the wiring increases, and the influence of the inductor component of the wiring increases.

FIG. 8 is a diagram showing the influence of the inductor of the wiring.

As the inductor component of the wiring increases, the value of ReZ when ImZ = 0 increases. Specifically, as shown in FIG. 8, it can be seen that the value of ReZ when ImZ = 0 increases as inductor component L increases to 0 nH, 20 nH, 50 nH, and 100 nH. Also, as the inductor component of the wiring increases, the shape of the semicircular portion that corresponds to the charge transfer resistance of the electrode also varies significantly. When the impedance of battery 3 subjected to measurement is low, the influence of the inductor component is relatively large. In order to suppress the influence, it is necessary to make the lengths of the wirings routed in battery pack 2 as short as possible, and thus the plurality of voltage detecting wires 17 are routed radially.

Also, as a result of current applying wire 14 being located between positive electrode-side battery terminal 25a and negative electrode-side battery terminal 25b of each of the plurality of batteries 3, current applying wire 14 that extends from battery monitoring device 1 to positive electrode-side assembled battery terminal 26a and negative electrode-side assembled battery terminal 26b of assembled battery 4 can be provided between positive electrode-side battery terminal 25a and negative electrode-side battery terminal 25b of each of the plurality of batteries 3. With this configuration, current applying wire 14 can be shortened, and the resistance value of current applying wire 14 can be made small, or in other words, the inductor component of current applying wire 14 can be reduced.

Also, a large AC current may be applied to current applying wire 14, and thus a mutual inductance that occurs when current applying wire 14 and voltage detecting wires 17 are provided in parallel also increases. To address this problem, by routing current applying wire 14 to prevent current applying wire 14 from being parallel to the plurality of voltage detecting wires 17, or by routing current applying wire 14 to minimize a portion of current applying wire 14 parallel to voltage detecting wires 17, it is possible to suppress an electromagnetic induction disturbance caused by the mutual inductance between current applying wire 14 and voltage detecting wires 17.

FIG. 9 is a diagram showing the influence of the electromagnetic induction disturbance.

In the case where the internal AC impedances of the plurality of batteries 3 are measured simultaneously, an AC current flows between battery monitoring device 1 and assembled battery 4 via current applying wire 14, and a magnetic field is generated around current applying wire 14. The generation of magnetic field is based on the Fleming's rule. The generated magnetic field is added to the amount of variation in the impedance measurement of battery 3 that is in the vicinity the magnetic field, and affects the internal AC impedance measurement of battery 3. In particular, the influence of the magnetic field appears remarkably when a high-frequency AC current is applied to current applying wire 14. As shown in FIG. 9, the influence in a high-frequency region in the Nyquist plot diagram appears significantly.

As described above, a phenomenon in which, due to a magnetic field, a circuit in the surroundings of the magnetic field is affected is called "electromagnetic induction disturbance". The magnetic field grows as the current of the generation source is larger and as the mutual inductance is larger. The mutual inductance is an inductance of a current loop created by a wiring or the like. The mutual inductance increases as the distance between the generation source and the influence receiving side is shorter, and as the number of portions in which the flowing current is parallel increases.

As described above, as a result of the plurality of voltage detecting wires 17 being routed radially from battery monitoring device 1, it is possible to measure the internal impedances (for example, internal AC impedances) of the plurality of batteries 3 that constitute assembled battery 4 with high accuracy.

Also, as a result of current applying wire 14 being routed to prevent the current applying wire from being parallel to the plurality of voltage detecting wires 17, or current applying wire 14 being routed to minimize a portion of current applying wire 14 parallel to voltage detecting wires 17, it is possible to measure the internal impedances (for example, internal AC impedances) of the plurality of batteries 3 that constitute assembled battery 4 with even higher accuracy.

Also, as a result of current applying wire 14 being located between positive electrode-side battery terminal 25a and negative electrode-side battery terminal 25b of each of the plurality of batteries 3, it is possible to measure the internal impedances (for example, internal AC impedances) of the plurality of batteries 3 that constitute assembled battery 4 with even higher accuracy.

### (Embodiment 2)

Next, battery pack 2a according to Embodiment 2 will be described.

A schematic configuration diagram showing an example of battery pack 2a according to Embodiment 2 is the same as the schematic configuration diagram (FIG. 1) of battery pack 2 according to Embodiment 1, and thus a description thereof is omitted here. Hereinafter, a structure of battery pack 2a according to Embodiment 2 will be described with reference to FIGS. 10 and 11, focusing on differences from battery pack 2 according to Embodiment 1.

FIG. 10 is a plan view showing an example of battery pack 2a according to Embodiment 2.

FIG. 11 is a perspective view showing the example of battery pack 2a according to Embodiment 2.

In Embodiment 2, as shown in FIGS. 10 and 11, current applying wire 14 is located outside the region between positive electrode-side battery terminal 25a and negative electrode-side battery terminal 25b of each of the plurality of batteries 3 when assembled battery 4 is viewed in a plan view. Battery monitoring device 1 is provided between positive electrode-side battery terminal 25a and negative electrode-side battery terminal 25b of each of the plurality of batteries 3 when assembled battery 4 is viewed in a plan view, and thus current applying wire 14 that is connected to battery monitoring device 1 includes portions that are located between positive electrode-side battery terminal 25a and negative electrode-side battery terminal 25b of adjacent batteries 3. However, a majority portion of current applying wire 14 is located outside the region between positive electrode-side battery terminal 25a and negative electrode-side battery terminal 25b of each of the plurality of batteries 3.

Because the plurality of voltage detecting wires 17 are routed between positive electrode-side battery terminal 25a and negative electrode-side battery terminal 25b of each of the plurality of batteries 3, as a result of current applying wire 14 being located outside the region between positive electrode-side battery terminal 25a and negative electrode-side battery terminal 25b of each of the plurality of batteries 3, the distance between voltage detecting wires 17 and current applying wire 14 can be increased. Accordingly, it is possible to suppress an electromagnetic induction disturbance caused by the mutual inductance between current applying wire 14 and voltage detecting wires 17, and measure the internal impedances (for example, internal AC impedances) of the plurality of batteries 3 that constitute assembled battery 4 with even higher accuracy.

As shown in FIGS. 10 and 11, in Embodiment 2 as well, current applying wire 14 may be routed to prevent the current applying wire from being parallel to the plurality of voltage detecting wires 17, or may be routed to minimize a portion of current applying wire 14 parallel to voltage detecting wires 17.

### (Embodiment 3)

Next, battery pack 2b according to Embodiment 3 will be described.

A schematic configuration diagram showing an example of battery pack 2b according to Embodiment 3 is the same as the schematic configuration diagram (FIG. 1) of battery pack 2 according to Embodiment 1, and thus a description thereof is omitted here. Hereinafter, a structure of battery pack 2b according to Embodiment 3 will be described with reference to FIGS. 12 and 13, focusing on differences from battery pack 2 according to Embodiment 1.

FIG. 12 is a plan view showing an example of battery pack 2b according to Embodiment 3.

FIG. 13 is a perspective view showing the example of battery pack 2b according to Embodiment 3.

In Embodiment 3, current applying wire 14 is routed to weaken the magnetic field generated by current applying wire 14. For example, as shown in FIGS. 12 and 13, current applying wire 14 may include a portion parallel to and oppose voltage detecting wires 17, and current applying wire 14 may be routed such that the direction of flowing current is opposite between one of opposing portions and the other portion. Specifically, current applying wire 14 may be routed in a square wave shape.

The magnetic field generated by current applying wire 14 is weakened, and it is therefore possible to suppress an electromagnetic induction disturbance caused by the mutual inductance between current applying wire 14 and voltage detecting wires 17. It is thereby possible to measure the internal impedances (for example, internal AC impedances) of the plurality of batteries 3 that constitute assembled battery 4 with even higher accuracy.

As shown in FIGS. 12 and 13, in Embodiment 3 as well, current applying wire 14 may be routed to prevent the current applying wire from being parallel to the plurality of voltage detecting wires 17, or may be routed to minimize a portion of current applying wire 14 parallel to voltage detecting wires 17. As a result of current applying wire 14 being routed in a square wave shape, voltage detecting wires 17 and current applying wire 14 are not arranged in parallel, and thus the influence of an electromagnetic induction disturbance can be suppressed.

Also, as a result of routing current applying wire 14 in the same direction as the current paths of currents flowing through batteries 3 and bus bars 23, the area of the current loop can be minimized, and thus the influence of an electromagnetic induction disturbance can be suppressed.

### (Embodiment 4)

Next, battery pack 2c according to Embodiment 4 will be described.

A schematic configuration diagram showing an example of battery pack 2c according to Embodiment 4 is the same as the schematic configuration diagram (FIG. 1) of battery pack 2 according to Embodiment 1, and thus a description thereof is omitted here. Hereinafter, a structure of battery pack 2c according to Embodiment 4 will be described with reference to FIGS. 14A to 16, focusing on differences from battery pack 2 according to Embodiment 1.

In Embodiment 4, battery pack 2c includes a shielding part that shields an electric field or a magnetic field generated by each of the plurality of batteries 3 or current applying wire 14. There are some implementations for the shielding part. Hereinafter, a first example, a second example, and a third example will be described.

FIG. 14A is a diagram illustrating a first example of the shielding part according to Embodiment 4. FIG. 14A is a cross-sectional view of current applying wire 14.

High-capacity battery 3 mounted in an automobile exhibits an impedance of several mΩ, and a large AC current may be applied to current applying wire 14 to increase the accuracy of impedance measurement. For this reason, current applying wire 14 may have a shielding function for shielding the electric field or the magnetic field. As shown in FIG. 14A, the shielding part may be shield 30 that covers conductor wire (center conductor) 27 of current applying wire 14, and current applying wire 14 may shield the electric field or the magnetic field generated by current applying wire 14. Shield 30 that has the shielding function for shielding the electric field or the magnetic fields is made using, for example, a metal tape made of copper, aluminum, or the like, or a mesh-like braided wire. For example, conductor wire 27 is covered by shield 30, shield 30 is covered by insulator 29, and insulator 29 is covered by jacket 28.

For reference, FIG. 14B shows an example of a wiring that is not covered by a shielding part. In this wiring, conductor wire 27 is covered directly by jacket 28.

As described above, with shield 30 that covers conductor wire 27 of current applying wire 14, it is possible to suppress the influence of the electric field or the magnetic field generated by current applying wire 14.

FIG. 15 is a diagram illustrating a second example of the shielding part according to Embodiment 4. FIG. 15 is a plan view of a second example of battery pack 2c according to Embodiment 4.

As shown in FIG. 15, the shielding part may be sheet-like shield 31 that is provided between current applying wire 14 and the plurality of voltage detecting wires 17, and may shield the electric field or the magnetic field generated by current applying wire 14. Sheet-like shield 31 is made using, for example, a metal plate that is made of copper, aluminum, or the like and has the shielding function of shielding the electric field or the magnetic field.

As described above, with sheet-like shield 31 provided between current applying wire 14 and the plurality of voltage detecting wires 17, it is possible to suppress the influence of the electric field or the magnetic field generated by current applying wire 14.

FIG. 16 is a diagram illustrating a third example of the shielding part according to Embodiment 4. FIG. 16 is a plan view of a third example of battery pack 2c according to Embodiment 4.

The shielding part may be sheet-like shield 32 that is provided between (i) the plurality of batteries 3 and (ii) current applying wire 14 and the plurality of voltage detecting wires 17, and may shield electric fields or magnetic fields generated by the plurality of batteries 3.

As described above, in the case where batteries 3 serve as sources of electric fields or magnetic fields, with sheet-like shield 32 that is provided between (i) the plurality of batteries 3 and (ii) current applying wire 14 and the plurality of voltage detecting wires 17, it is possible to suppress the influence of electric fields or magnetic fields generated by the plurality of batteries 3.

### (Embodiment 5)

Next, battery pack 2d according to Embodiment 5 will be described.

A schematic configuration diagram showing an example of battery pack 2d according to Embodiment 5 is the same as the schematic configuration diagram (FIG. 1) of battery pack 2 according to Embodiment 1, and thus a description thereof is omitted here. Hereinafter, a structure of battery pack 2d according to Embodiment 5 will be described with reference to FIG. 17, focusing on differences from battery pack 2 according to Embodiment 1.

FIG. 17 is a plan view showing an example of battery pack 2d according to Embodiment 5.

In Embodiment 5, battery monitoring device 1 is located at a position that is at an end of assembled battery 4 in the lengthwise direction (Y axis direction) and substantially at the center of assembled battery 4 in the widthwise direction (X axis direction) when assembled battery 4 is viewed in a plan view. As described above, battery monitoring device 1 may be located at an end of assembled battery 4, and the plurality of voltage detecting wires 17 may be routed radially in the shape of a fan from battery monitoring device 1 when assembled battery 4 is viewed in a plan view.

### (Embodiment 6)

Next, battery pack 2e according to Embodiment 6 will be described.

FIG. 18 is a schematic configuration diagram showing an example of battery pack 2e according to Embodiment 6. The following description will be given with reference to FIG. 18, focusing on differences from battery pack 2 according to Embodiment 1.

In Embodiment 1, an example as shown in FIG. 1 was described in which voltage detecting wires 17 are connected to positive electrode-side battery terminal 25a and negative electrode-side battery terminal 25b of each of the plurality of batteries 3, specifically, sixteen voltage detecting wires 17 are provided for eight batteries B1 to B8. However, because positive electrode-side battery terminal 25a and negative electrode-side battery terminal 25b of each pair of adjacent batteries 3 are connected by bus bar 23, each bus bar 23 has substantially the same potential as that of positive electrode-side battery terminal 25a and negative electrode-side battery terminal 25b. Accordingly, instead of connecting voltage detecting wires 17 to positive electrode-side battery terminal 25a and negative electrode-side battery terminal 25b of each of the plurality of batteries 3, the voltages of adjacent batteries 3 can also be detected by simply connecting voltage detecting wires 17 to bus bars 23. For example, as shown in FIG. 18, nine voltage detecting wires 17 can be connected to eight batteries B1 to B8, which can reduce the number of voltage detecting wires 17.

Next, a structure of battery pack 2e according to Embodiment 6 will be described with reference to FIGS. 19 and 20.

FIG. 19 is a plan view showing an example of battery pack 2e according to Embodiment 6.

FIG. 20 is a perspective view showing an example of battery pack 2e according to Embodiment 6.

As shown in FIGS. 19 and 20, assembled battery 4 is configured by, using bus bar 23, connecting battery terminal 25 of battery 3 included in the plurality of batteries 3 to battery terminal 25 of adjacent battery 3 included in the plurality of batteries 3, and voltage detecting wire 17 included in the plurality of voltage detecting wires 17 is connected to bus bar 23 at a position between two battery terminals 25 (positive electrode-side battery terminal 25a and negative electrode-side battery terminal 25b). Instead of bus bars 23, positive electrode-side assembled battery terminal 26a and negative electrode-side assembled battery terminal 26b are connected respectively to positive electrode-side battery terminal 25a of battery 3 located on one end side and negative electrode-side battery terminal 25b of battery 3 located on the other end side included in the plurality of batteries 3 that are connected in series, and voltage detecting wires 17 are connected to positive electrode-side assembled battery terminal 26a and negative electrode-side assembled battery terminal 26b, respectively. With this configuration, the number of voltage detecting wires 17 can be reduced, and the influence of inductor component and induced electromotive force during impedance measurement of batteries 3 can be suppressed in accordance with the reduction in the number of voltage detecting wires 17. Accordingly, it is possible to measure the internal impedance (for example, internal AC impedance) of each of the plurality of batteries 3 that constitute assembled battery 4 with even higher accuracy.

Voltage detecting wire 17 (for example, each of the plurality of voltage detecting wires 17) may be connected to bus bar 23 at a position that is substantially the center of two battery terminals 25 (positive electrode-side battery terminal 25a and negative electrode-side battery terminal 25b) (the position being equidistant from two battery terminals 25). As a result of voltage detecting wire 17 (for example, each of the plurality of voltage detecting wires 17) being connected to bus bar 23 at the position equidistant from two battery terminals 25, the influence of resistance component of bus bar 23 during detection of the voltages of adjacent batteries 3 can be made equal between the adjacent batteries 3. As used herein, the term "equidistant" encompasses not only the case where two distances completely match, but also the case where two distances are different by an amount of several percent.

### (Other Embodiments)

The battery packs according a plurality of aspects of the present disclosure have been described above based on embodiments. However, the present disclosure is not limited to the embodiments given above. The plurality of aspects of the present disclosure also encompass other embodiments obtained by making various modifications that can be conceived by a person having ordinary skill in the art to the above embodiments as well as embodiments implemented by any combination of the structural elements of different embodiments without departing from the scope of the plurality of aspects of the present disclosure.

For example, in the embodiments given above, an example was described in which current applying wire 14 and voltage detecting wires 17 are conductor wires, but the present disclosure is not limited thereto. This will be described with reference to FIG. 21.

FIG. 21 is a plan view showing an example of battery pack 2f according to another embodiment.

As shown in FIG. 21, circuit board 33 may be provided on the upper surface side of assembled battery 4 to be connected to battery terminals 25 of the plurality of batteries 3 that constitute assembled battery 4. Battery monitoring device 1 may be mounted on circuit board 33, and current applying wire 14 and voltage detecting wires 17 may be formed by a wiring pattern (conductive metal) formed on circuit board 33. Circuit board 33 may be a printed circuit board (PCB), a flexible printed circuit (FPC), or the like.

For example, in the embodiments given above, an example was described in which batteries 3 are prismatic batteries. However, batteries 3 may have other shapes such as a cylindrical shape or a flat plate shape.

For example, in the embodiments given above, an example was described in which the battery pack is applied to a power supply system in a vehicle. However, the battery pack is also effectively used in a storage battery, a motorbike, heavy equipment, watercraft, aircraft, a power generation plant, and the like. Also, an example was described in which batteries 3 are lithium-ion batteries. However, batteries 3 may be other secondary batteries (lead storage batteries, nickel cadmium storage batteries, metal lithium batteries, lithium-ion polymer secondary batteries, sodium-ion batteries, solid-state batteries, or the like).

### [Industrial Applicability]

The present disclosure is applicable to a battery pack that functions to monitor the state of a secondary battery such as a lithium-ion battery.

### [Reference Signs List]

- 1: battery monitoring device
- 2, 2a, 2b, 2c, 2d, 2e, 2f: battery pack
- 3: battery
- 4: assembled battery
- 5: load
- 6: relay
- 7: battery manager
- 8: load resistor
- 9: switching element
- 10, 21: shunt resistor
- 11: controller
- 12: signal generator
- 13: AC current measurer
- 14: current applying wire
- 15: voltage measurer
- 16: timing generator
- 17: voltage detecting wire
- 18: impedance computing unit
- 19: communicator
- 20: higher-level controller
- 22: current measurer
- 23: bus bar
- 24: housing
- 25: battery terminal
- 25a: positive electrode-side battery terminal
- 25b: negative electrode-side battery terminal
- 26a: positive electrode-side assembled battery terminal
- 26b: negative electrode-side assembled battery terminal
- 27: conductor wire
- 28: jacket
- 29: insulator
- 30: shield
- 31, 32: sheet-like shield
- 33: circuit board

## Claims

1. A battery pack (2) comprising:
an assembled battery (4) in which a plurality of batteries (3) are connected;
a current applying wire (14) for applying an electric current to the assembled battery;
a plurality of voltage detecting wires (17) for detecting voltages of the plurality of batteries; and
a battery monitoring device (1) that measures internal impedances of the plurality of batteries,
wherein the battery monitoring device is located between a positive electrode-side battery terminal and a negative electrode-side battery terminal of each of the plurality of batteries included in the assembled battery, and
the plurality of voltage detecting wires are routed radially from the battery monitoring device.

2. The battery pack according to claim 1,
wherein the assembled battery and the battery monitoring device are connected using the current applying wire, and
an alternating (AC) current controlled by the battery monitoring device is applied to the assembled battery via the current applying wire.

3. The battery pack according to claim 1 or 2,
wherein the battery monitoring device measures internal AC impedances of the plurality of batteries based on the AC current applied to the assembled battery and the voltages of the plurality of batteries.

4. The battery pack according to any one of claims 1 to 3,
wherein the current applying wire is routed to prevent the current applying wire from being parallel to the plurality of voltage detecting wires, or routed to minimize a portion of the current applying wire parallel to the plurality of voltage detecting wires.

5. The battery pack according to any one of claims 1 to 4,
wherein the current applying wire is located between the positive electrode-side battery terminal and the negative electrode-side battery terminal of each of the plurality of batteries.

6. The battery pack according to any one of claims 1 to 4,
wherein the current applying wire is located outside a region between the positive electrode-side battery terminal and the negative electrode-side battery terminal of each of the plurality of batteries.

7. The battery pack according to any one of claims 1 to 6,
wherein the current applying wire is routed to weaken a magnetic field generated by the current applying wire.

8. The battery pack according to any one of claims 1 to 7,
wherein the assembled battery is configured by connecting, using a bus bar, a battery terminal of a battery included in the plurality of batteries to a battery terminal of an adjacent battery included in the plurality of batteries, the adjacent battery being adjacent to the battery, and
a voltage detecting wire included in the plurality of voltage detecting wires is connected to the bus bar at a position between the two battery terminals.

9. The battery pack according to claim 8,
wherein the voltage detecting wire included in the plurality of voltage detecting wire is connected to the bus bar at the position equidistant from the two battery terminals.

10. The battery pack according to any one of claims 1 to 9, comprising:
a shielding part that shields an electric field or a magnetic field generated by each of the plurality of batteries or the current applying wire.

11. The battery pack according to claim 10,
wherein the shielding part is a shield that covers a center conductor of the current applying wire, and shields the electric field or the magnetic field generated by the current applying wire.

12. The battery pack according to claim 10 or 11,
wherein the shielding part is a sheet-like shield provided between the current applying wire and the plurality of voltage detecting wires, and shields the electric field or the magnetic field generated by the current applying wire.

13. The battery pack according to any one of claims 10 to 12,
wherein the shielding part is a sheet-like shield provided between (i) the plurality of batteries and (ii) the current applying wire and the plurality of voltage detecting wires, and shields the electric field or the magnetic field generated by each of the plurality of batteries.

## Patentansprüche

1. Batteriepack (2), umfassend: eine zusammengebaute Batterie (4), in der eine Vielzahl von Batterien (3) verbunden sind; einen Stromanlegedraht (14) zum Anlegen eines elektrischen Stroms an die zusammengebaute Batterie; eine Vielzahl von Spannungserfassungsdrähten (17) zum Erfassen von Spannungen der Vielzahl von Batterien; und eine Batterieüberwachungsvorrichtung (1), die interne Impedanzen der Vielzahl von Batterien misst, wobei die Batterieüberwachungsvorrichtung zwischen einem Batterieanschluss auf der Seite der positiven Elektrode und einem Batterieanschluss auf der Seite der negativen Elektrode jeder der Vielzahl von Batterien, die in der zusammengebauten Batterie enthalten sind, angeordnet ist, und die Vielzahl von Spannungserfassungsdrähten von der Batterieüberwachungsvorrichtung radial geführt sind.

2. Batteriepack nach Anspruch 1, wobei die zusammengebaute Batterie und die Batterieüberwachungsvorrichtung unter Verwendung des Stromanlegedrahts verbunden sind, und ein von der Batterieüberwachungsvorrichtung gesteuerter Wechselstrom (AC) über den Stromanlegedraht an die zusammengebaute Batterie angelegt wird.

3. Batteriepack nach Anspruch 1 oder 2, wobei die Batterieüberwachungsvorrichtung interne AC-Impedanzen der Vielzahl von Batterien basierend auf dem an die zusammengebaute Batterie angelegten AC-Strom und den Spannungen der Vielzahl von Batterien misst.

4. Batteriepack nach einem der Ansprüche 1 bis 3, wobei der Stromanlegedraht so geführt ist, dass verhindert wird, dass der Stromanlegedraht parallel zu der Vielzahl von Spannungserfassungsdrähten verläuft, oder so geführt ist, dass ein Abschnitt des Stromanlegedrahts parallel zu der Vielzahl von Spannungserfassungsdrähten minimiert wird.

5. Batteriepack nach einem der Ansprüche 1 bis 4, wobei der Stromanlegedraht zwischen dem Batterieanschluss auf der Seite der positiven Elektrode und dem Batterieanschluss auf der Seite der negativen Elektrode jeder der Vielzahl von Batterien angeordnet ist.

6. Batteriepack nach einem der Ansprüche 1 bis 4, wobei der Stromanlegedraht außerhalb eines Bereichs zwischen dem Batterieanschluss auf der Seite der positiven Elektrode und dem Batterieanschluss auf der Seite der negativen Elektrode jeder der Vielzahl von Batterien angeordnet ist.

7. Batteriepack nach einem der Ansprüche 1 bis 6, wobei der Stromanlegedraht so geführt ist, dass ein durch den Stromanlegedraht erzeugtes Magnetfeld abgeschwächt wird.

8. Batteriepack nach einem der Ansprüche 1 bis 7, wobei die zusammengebaute Batterie konfiguriert ist, indem unter Verwendung einer Sammelschiene ein Batterieanschluss einer in der Vielzahl von Batterien enthaltenen Batterie mit einem Batterieanschluss einer in der Vielzahl von Batterien enthaltenen benachbarten Batterie verbunden wird, wobei die benachbarte Batterie der Batterie benachbart ist, und ein in der Vielzahl von Spannungserfassungsdrähten enthaltener Spannungserfassungsdraht an einer Position zwischen den zwei Batterieanschlüssen mit der Sammelschiene verbunden ist.

9. Batteriepack nach Anspruch 8, wobei der in der Vielzahl von Spannungserfassungsdrähten enthaltene Spannungserfassungsdraht an der von den zwei Batterieanschlüssen äquidistanten position mit der Sammelschiene verbunden ist.

10. Batteriepack nach einem der Ansprüche 1 bis 9, umfassend: ein Abschirmteil, das ein elektrisches Feld oder ein Magnetfeld abschirmt, das von jeder der Vielzahl von Batterien oder dem Stromanlegedraht erzeugt wird.

11. Batteriepack nach Anspruch 10, wobei das Abschirmteil eine Abschirmung ist, die einen Mittelleiter des Stromanlegedrahts bedeckt und das elektrische Feld oder das Magnetfeld abschirmt, das durch den Stromanlegedraht erzeugt wird.

12. Batteriepack nach Anspruch 10 oder 11, wobei das Abschirmteil eine blattartige Abschirmung ist, die zwischen dem Stromanlegedraht und der Vielzahl von Spannungserfassungsdrähten vorgesehen ist und das elektrische Feld oder das Magnetfeld abschirmt, das durch den Stromanlegedraht erzeugt wird.

13. Batteriepack nach einem der Ansprüche 10 bis 12, wobei das Abschirmteil eine blattartige Abschirmung ist, die zwischen (i) der Vielzahl von Batterien und (ii) dem Stromanlegedraht und der Vielzahl von Spannungserfassungsdrähten vorgesehen ist und das elektrische Feld oder das Magnetfeld abschirmt, das von jeder der Vielzahl von Batterien erzeugt wird.

## Revendications

1. Bloc-batterie (2) comprenant : une batterie assemblée (4) dans laquelle une pluralité de batteries (3) sont connectées ; un fil d'application de courant (14) pour appliquer un courant électrique à la batterie assemblée ; une pluralité de fils de détection de tension (17) pour détecter des tensions de la pluralité de batteries ; et un dispositif de surveillance de batterie (1) qui mesure des impédances internes de la pluralité de batteries, dans lequel le dispositif de surveillance de batterie est situé entre une borne de batterie côté électrode positive et une borne de batterie côté électrode négative de chacune de la pluralité de batteries incluses dans la batterie assemblée, et la pluralité de fils de détection de tension sont acheminés radialement depuis le dispositif de surveillance de batterie.

2. Bloc-batterie selon la revendication 1, dans lequel la batterie assemblée et le dispositif de surveillance de batterie sont connectés en utilisant le fil d'application de courant, et un courant alternatif (CA) commandé par le dispositif de surveillance de batterie est appliqué à la batterie assemblée via le fil d'application de courant.

3. Bloc-batterie selon la revendication 1 ou 2, dans lequel le dispositif de surveillance de batterie mesure des impédances CA internes de la pluralité de batteries sur la base du courant CA appliqué à la batterie assemblée et des tensions de la pluralité de batteries.

4. Bloc-batterie selon l'une quelconque des revendications 1 à 3, dans lequel le fil d'application de courant est acheminé pour empêcher le fil d'application de courant d'être parallèle à la pluralité de fils de détection de tension, ou acheminé pour minimiser une portion du fil d'application de courant parallèle à la pluralité de fils de détection de tension.

5. Bloc-batterie selon l'une quelconque des revendications 1 à 4, dans lequel le fil d'application de courant est situé entre la borne de batterie côté électrode positive et la borne de batterie côté électrode négative de chacune de la pluralité de batteries.

6. Bloc-batterie selon l'une quelconque des revendications 1 à 4, dans lequel le fil d'application de courant est situé à l'extérieur d'une région entre la borne de batterie côté électrode positive et la borne de batterie côté électrode négative de chacune de la pluralité de batteries.

7. Bloc-batterie selon l'une quelconque des revendications 1 à 6, dans lequel le fil d'application de courant est acheminé pour affaiblir un champ magnétique généré par le fil d'application de courant.

8. Bloc-batterie selon l'une quelconque des revendications 1 à 7, dans lequel la batterie assemblée est configurée en connectant, en utilisant une barre omnibus, une borne de batterie d'une batterie incluse dans la pluralité de batteries à une borne de batterie d'une batterie adjacente incluse dans la pluralité de batteries, la batterie adjacente étant adjacente à la batterie, et un fil de détection de tension inclus dans la pluralité de fils de détection de tension est connecté à la barre omnibus à une position entre les deux bornes de batterie.

9. Bloc-batterie selon la revendication 8, dans lequel le fil de détection de tension inclus dans la pluralité de fils de détection de tension est connecté à la barre omnibus à la position équidistante des deux bornes de batterie.

10. Bloc-batterie selon l'une quelconque des revendications 1 à 9, comprenant : une partie de blindage qui blinde un champ électrique ou un champ magnétique généré par chacune de la pluralité de batteries ou le fil d'application de courant.

11. Bloc-batterie selon la revendication 10, dans lequel la partie de blindage est un blindage qui recouvre un conducteur central du fil d'application de courant, et blinde le champ électrique ou le champ magnétique généré par le fil d'application de courant.

12. Bloc-batterie selon la revendication 10 ou 11, dans lequel la partie de blindage est un blindage en forme de feuille disposé entre le fil d'application de courant et la pluralité de fils de détection de tension, et blinde le champ électrique ou le champ magnétique généré par le fil d'application de courant.

13. Bloc-batterie selon l'une quelconque des revendications 10 à 12, dans lequel la partie de blindage est un blindage en forme de feuille disposé entre (i) la pluralité de batteries et (ii) le fil d'application de courant et la pluralité de fils de détection de tension, et blinde le champ électrique ou le champ magnétique généré par chacune de la pluralité de batteries.
